(19) Europäisches Patentamt
European Patent Office
Office européen des brevets

(11) **EP 3 523 457 B1**

(12) **FASCICULE DE BREVET EUROPEEN**

(45) Date de publication et mention de la délivrance du brevet:
**12.02.2020 Bulletin 2020/07**

(21) Numéro de dépôt: **17784580.7**

(22) Date de dépôt: **29.09.2017**

(51) Int Cl.:
**C23C 16/455** (2006.01)     **C23C 16/509** (2006.01)
**H01J 37/32** (2006.01)

(86) Numéro de dépôt international:
**PCT/EP2017/074799**

(87) Numéro de publication internationale:
**WO 2018/065315 (12.04.2018 Gazette 2018/15)**

(54) **DISPOSITIF POUR AMENER UN GAZ DANS UN REACTEUR DE DEPOT CHIMIQUE EN PHASE GAZEUSE**

VORRICHTUNG ZUM FÖRDERN EINES GASES IN EINEM CVD-REAKTOR

DEVICE FOR CONVEYING A GAS INTO A CHEMICAL VAPOUR DEPOSITION REACTOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.10.2016 FR 1659559**

(43) Date de publication de la demande:
**14.08.2019 Bulletin 2019/33**

(73) Titulaire: **Kobus SAS**
**38330 Montbonnot-Saint-Martin (FR)**

(72) Inventeurs:
• **NAL, Patrice**
  **38000 Grenoble (FR)**
• **BOREAN, Christophe**
  **38660 Le Touvet (FR)**

(74) Mandataire: **IP Trust**
**2, rue de Clichy**
**75009 Paris (FR)**

(56) Documents cités:
**US-A- 5 755 886**     **US-A1- 2009 324 847**
**US-A1- 2011 220 026**

**Description**

**DOMAINE DE L'INVENTION**

La présente invention concerne un dispositif pour amener un gaz dans un réacteur de dépôt chimique en phase gazeuse permettant de conditionner électriquement le gaz circulant dans une conduite. L'invention concerne plus particulièrement un tel dispositif permettant d'éviter que le gaz circulant dans une telle conduite ne soit soumis localement à un champ électrique excessif du fait d'un potentiel électrique imposé à la sortie de ladite conduite débouchant dans le réacteur.

**ETAT DE LA TECHNIQUE**

Le dépôt chimique par voie gazeuse est couramment désigné par sa dénomination anglo-saxonne « chemical vapor deposition » (CVD). Ce procédé peut notamment être mis en oeuvre pour déposer une couche mince à la surface d'un substrat à partir de gaz réactionnels par le biais de réactions chimiques, en particulier pour la fabrication de semiconducteurs. Dans ce cas, les gaz réactionnels comprennent un gaz précurseur injecté dans la chambre de dépôt du réacteur par exemple par une première voie d'injection et un gaz réactant injecté dans la chambre de dépôt du réacteur par exemple par une deuxième voie d'injection distincte de la première, de manière à ne se mélanger qu'une fois qu'ils ont pénétré dans ladite chambre de dépôt.

Parmi les variantes existantes du procédé CVD, le procédé de dépôt chimique par voie gazeuse assisté par plasma, ou « plasma enhanced chemical vapor deposition » (PECVD), présente un intérêt tout particulier. Il comprend la formation d'un plasma à partir des gaz réactionnels par apport d'énergie électrique d'une source radiofréquence qui génère une différence de potentiel radiofréquence ($V_{RF}$) suffisamment élevée entre deux électrodes ou deux parties du dispositif faisant office d'électrodes. Le plasma apporte l'énergie nécessaire au déroulement du dépôt de la couche mince à la surface du substrat tout en limitant l'apport d'énergie thermique, en maintenant les électrons à un haut niveau d'excitation. Ainsi, le procédé PECVD peut être mis en oeuvre à des températures nettement plus basses que d'autres variantes du procédé CVD, et permet de réaliser des dépôts de couches de bonne qualité.

En pratique, la sortie des conduites de gaz qui permettent d'injecter les gaz réactionnels dans la chambre est généralement portée au potentiel radiofréquence par la source radiofréquence. Le substrat à traiter a quant à lui un potentiel nul, ou du moins correspondant au potentiel de masse du circuit électrique. Cette différence de potentiel génère un plasma à l'intérieur de la chambre en provoquant l'ionisation des gaz réactionnels. Cette dernière provoque la dissociation du gaz précurseur, puis la formation de la couche souhaitée sur le substrat par réactions du gaz précurseur avec le gaz réactant, et ainsi la formation d'une couche à la surface du substrat.

La présence d'un potentiel $V_{RF}$ à la sortie de la conduite de gaz présente cependant l'inconvénient de risquer de provoquer l'ionisation partielle du gaz réactionnel, en particulier du gaz précurseur et/ou du gaz réactant dans leur conduite de circulation respective, avant même leur entrée dans la chambre du réacteur. En effet, l'entrée de la conduite ou du moins des portions en amont de sa sortie sont également au potentiel nul, correspondant au potentiel de masse du circuit électrique. Cette différence de potentiel entre la sortie de la conduite et une portion amont de ladite conduite peut provoquer la formation d'un plasma de gaz dans la conduite de circulation de gaz, et dégrader la qualité du dépôt.

Afin de résoudre ce problème, il est connu de mettre en oeuvre un manchon résistif qui peut se présenter sous la forme d'une gaine en matériau électriquement résistif entourant les conduites de circulation de gaz. La résistance électrique totale du manchon est choisie de sorte à limiter l'apport d'énergie dans le gaz et éviter ainsi les risques de claquage et d'apparition de plasma.

On connaît par exemple le brevet US 6,170,430 qui décrit la mise en œuvre d'une gaine résistive autour des conduites de gaz permettant de former un gradient linéaire de tension électrique le long desdites conduites de gaz. D'autres diapositifs sont connus de US2009/0324847 et US5755886.

Toutefois, de telles gaines résistives ne sont pas suffisantes pour prévenir tout risque d'apparition de plasma dans les conduites, en particulier dans les procédés de PECVD dans lesquels la pression dans les conduites varie (par exemple du fait d'injections de gaz par impulsions...). En effet, comme l'impédance locale du gaz dans la conduite dépend de la pression, il peut être possible d'atteindre localement une tension de claquage même en imposant un gradient de tension linéaire.

**EXPOSE DE L'INVENTION**

La présente invention a donc pour but de remédier aux inconvénients de l'art antérieur en proposant un dispositif de circulation de gaz permettant un conditionnement électrique d'un gaz circulant dans une conduite destiné à éviter la formation de plasma dans ladite conduite de circulation de gaz.

Un objet de l'invention est un dispositif de circulation de gaz pour amener un gaz dans un réacteur de dépôt chimique en phase gazeuse, comprenant une conduite avec une première extrémité destinée à déboucher dans ledit réacteur en étant polarisée à un potentiel radiofréquence et une seconde extrémité électriquement polarisée à un potentiel de référence, le dispositif étant caractérisé en ce que la conduite comprend au moins une partie conductrice à l'électricité agencée de sorte à être en contact avec le gaz circulant dans la conduite et environnée de parties isolantes à l'électricité, et en ce qu'il comprend en outre un moyen d'application de potentiel pour appliquer localement au moins un potentiel électrique déterminé à la conduite entre la première et la seconde extrémité, de sorte à polariser localement le gaz dans ladite conduite à un potentiel électrique intermédiaire entre le potentiel radiofréquence et le potentiel de référence.

Par « conditionnement électrique », on entend dans le présent texte le fait d'imposer une ou plusieurs tensions électriques déterminées au gaz circulant dans la conduite.

Le dispositif selon l'invention vise également à permettre d'éviter la formation de plasma dans la conduite de circulation de gaz en présence de variations importantes de pression d'injection des gaz, par exemple lors d'injections impulsionnelles dudit gaz.

Selon un mode de réalisation, le moyen d'application de potentiel comprend au moins une source de tension agencée de sorte à imposer un potentiel à une portion de la conduite.

Selon un autre mode de réalisation, le moyen d'application de potentiel comprend un diviseur de tension électriquement relié selon deux bornes respectivement au potentiel de la première et la seconde extrémité de la conduite, ledit diviseur de tension comprenant une pluralité de modules d'impédance électrique reliés en série, au moins une jonction entre deux modules d'impédance électrique successifs étant reliée électriquement à la conduite.

De manière avantageuse, le dispositif comprend un module d'impédance électrique avec au moins l'un des composants suivants : une résistance, une inductance, une bobine, un condensateur.

La conduite peut comprendre une partie isolante à l'électricité de la forme d'une section de ladite conduite.

Par ailleurs, la conduite peut comprendre une partie conductrice à l'électricité de la forme d'une section de ladite conduite.

Selon un mode de réalisation, la conduite a une section intérieure sensiblement uniforme.

En particulier, la conduite peut comprendre une partie isolante à l'électricité de la forme d'une section de tube.

Selon un mode de réalisation, la conduite comprend au moins une partie conductrice à l'électricité sous la forme d'une pièce en matériau conducteur à l'électricité avec au moins une chambre traversante de circulation de gaz.

Ladite chambre traversante peut définir un parcours non rectiligne du gaz dans ladite partie conductrice à l'électricité.

Selon un mode de réalisation, la conduite comprend au moins une partie conductrice à l'électricité sous la forme d'une pièce en matériau conducteur à l'électricité avec une pluralité d'ouvertures permettant la circulation du gaz.

Un autre objet de l'invention est de proposer un réacteur pour le dépôt chimique en phase gazeuse comprenant un ou plusieurs dispositifs de circulation de gaz avec un tel dispositif de conditionnement électrique, permettant d'éviter la formation de plasma dans la ou les conduites de circulation de gaz.

Selon un mode de réalisation, ledit réacteur comprend deux électrodes, dont une première électrode est reliée à une source radiofréquence, et une seconde électrode est reliée à la masse, de sorte que la différence de potentiel entre la première et la seconde électrode permet de former un plasma du ou des gaz injecté(s) dans le réacteur.

Un troisième objet de l'invention concerne un procédé pour éviter la formation de plasma dans une conduite d'injection de gaz d'un réacteur de dépôt chimique en phase gazeuse, tel que le réacteur décrit précédemment, ledit réacteur comprenant une conduite avec une première extrémité débouchant dans ledit réacteur en étant polarisée à un potentiel radiofréquence et une seconde extrémité électriquement polarisée à un potentiel de référence, la conduite comprenant au moins une partie conductrice à l'électricité agencée de sorte à être en contact avec le gaz circulant dans la conduite et environnée de parties isolantes à l'électricité. Ledit procédé est caractérisé en ce qu'il comprend une application localement d'au moins un potentiel électrique déterminé à la conduite entre la première et la seconde extrémité, de sorte à polariser localement le gaz dans ladite conduite à un potentiel électrique intermédiaire entre le potentiel radiofréquence et le potentiel de référence.

Un quatrième objet de l'invention concerne un procédé de dépôt chimique en phase gazeuse mis en œuvre par le réacteur décrit précédemment.

Ce procédé comprend l'injection d'un ou plusieurs gaz destiné(s) à réagir à la surface d'un substrat préalablement positionné dans la chambre de réaction du réacteur via un dispositif de circulation de gaz tel que décrit plus haut.

Ainsi, l'invention permet d'imposer des potentiels électriques prédéterminés au gaz en fonction de la position dans la conduite. Elle permet ainsi d'imposer tout profil de potentiel le long de la conduite.

Le profil de potentiel ainsi peut être notamment linéaire, non-linéaire, quadratique, logarithmique, ....

Le profil de potentiel peut également être proportionnel, inversement proportionnel, ou fonction d'un profil de pression de gaz en fonction de la position dans la conduite.

Le profil de potentiel imposé est essentiellement linéaire par morceaux. En appliquant à chaque partie conductrice à l'électricité un potentiel électrique déterminé, on impose ainsi au gaz entre deux parties conductrices successives une différence de potentiel également déterminée. On y génère ainsi un champ électrique local qui dépend de la distance entre les parties conductrices et de la différence de potentiel.

Le profil du potentiel ou du champ électrique local peut être modulé, par exemple :

- En disposant les parties conductrices successives de manière non équidistante, ou en d'autres termes en intercalant entre les parties conductrices des parties isolantes de longueur variable ou différente ; et/ou
- En appliquant des potentiels aux parties conductrices générant des différences de potentiel différentes pour différentes parties isolantes. Pour cela, on peut par exemple utiliser un diviseur de tension avec des modules d'impédance électrique successifs de valeur différente.

Bien entendu, on peut également mettre en œuvre l'invention avec :

- Des parties isolantes de longueur identique sur tout ou partie de la conduite ; et/ou
- Des modules d'impédance électrique successifs de valeur identique sur tout ou partie de la conduite.

De préférence, les parties conductrices sont directement en contact avec le gaz, ce qui permet d'assurer un écoulement des charges électriques optimal et une bonne homogénéité sur une section de la conduite du potentiel électrique appliqué.

## DESCRIPTION DES FIGURES

D'autres avantages et caractéristiques de l'invention apparaîtront à la lecture de la description suivante donnée à titre d'exemple illustratif et non limitatif, en référence aux dessins annexés sur lesquels :

- la figure 1 qui représente un schéma de la structure du dispositif de conditionnement électrique d'une conduite de circulation de gaz selon un premier objet de l'invention, la conduite débouchant dans le réacteur de dépôt chimique en phase gazeuse assisté par plasma (PECVD) selon un deuxième objet de l'invention ;
- la figure 2 représente de manière schématique une forme d'exécution d'une partie électriquement conductrice de la conduite.

## DESCRIPTION DETAILLEE DE L'INVENTION

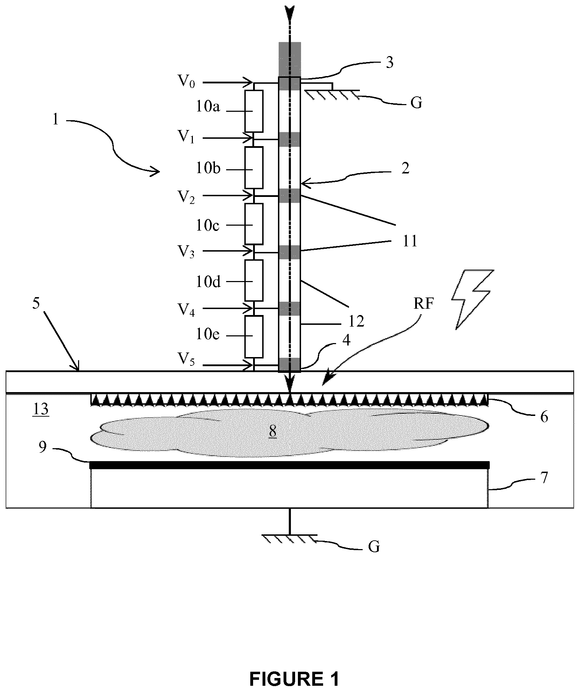

Un premier objet de l'invention concerne un dispositif 1 de circulation de gaz pour amener un gaz dans un réacteur de dépôt chimique en phase gazeuse, dont la structure est représentée sur la Figure 1.

Le dispositif comprend une conduite de gaz 2 qui est destinée à amener le gaz depuis une source (non représentée) vers la chambre du réacteur, dans le sens de la flèche confondue avec l'axe de symétrie de ladite conduite.

L'entrée 3 de la conduite de gaz est située au niveau d'une première extrémité, et est reliée à un potentiel électrique de référence qui, dans le mode de réalisation présenté, correspond à la masse G du circuit électrique. Son potentiel électrique $V_0$ est donc nul.

La sortie 4 de la conduite est quant à elle située au niveau d'une seconde extrémité, et est reliée à une source radiofréquence RF qui lui impose un potentiel électrique $V_5 = V_{RF}$ à une fréquence élevée (typiquement de 13,56 MHz).

Ainsi, la conduite 2 de gaz est soumise à une différence de potentiel entre ses bornes 3 et 4, égale à $V_5 - V_0$.

Le conditionnement électrique du gaz circulant dans la conduite consiste à imposer localement au moins un potentiel électrique déterminé audit gaz, ledit potentiel étant intermédiaire entre le potentiel radiofréquence $V_5$ et le potentiel de référence $V_0$.

Ainsi, le gaz circulant dans la conduite est soumis, entre deux zones où le potentiel est imposé, à une différence de potentiel inférieure à la différence de potentiel $V_5 - V_0$, suffisamment faible pour minimiser les risques de génération de plasma au sein de la conduite.

De manière avantageuse, on peut diviser ainsi la différence de potentiel $V_5 - V_0$ en autant de différences de potentiel que nécessaire, localisées le long de la conduite. Cela permet de mieux contrôler ou maîtriser les valeurs locales du champ électrique dans la conduite, et s'assurer que ce champ électrique n'atteint jamais, même localement, une intensité suffisante pour générer un plasma.

A cet effet, la conduite comprend au moins une partie conductrice à l'électricité agencée de sorte à être en contact avec le gaz circulant dans ladite conduite et environnée de parties isolantes à l'électricité. Dans le mode de réalisation de la figure 1, les parties conductrices à l'électricité sont grisées et désignées par le repère 11, tandis que les parties isolantes à l'électricité sont blanches et désignées par le repère 12.

De préférence, chaque partie conductrice à l'électricité se présente sous la forme d'une pièce en matériau conducteur à l'électricité définissant intérieurement au moins un canal traversant de circulation de gaz. Extérieurement, ladite partie conductrice à l'électricité comprend tout moyen adapté pour l'application d'un potentiel électrique. L'homme du métier est en mesure de concevoir tout connecteur électrique approprié à cet effet.

L'application dudit potentiel au gaz est d'autant plus efficace que la surface de contact entre le gaz et la partie électriquement conductrice est grande. Par conséquent, on fait de préférence en sorte que la partie électriquement conductrice s'étende sur une certaine longueur du flux de gaz en entourant entièrement ledit flux de gaz.

Ainsi, de manière avantageuse, ladite partie conductrice à l'électricité forme une section de la conduite.

De part et d'autre de cette partie conductrice à l'électricité s'étendent des parties isolantes à l'électricité, qui forment de préférence chacune une section de la conduite.

De manière avantageuse, chaque partie isolante à l'électricité a la forme d'une section de tube, comme dans une conduite conventionnelle.

De préférence, la conduite a une section intérieure sensiblement uniforme. Notamment, le dispositif de circulation est conçu pour éviter des variations de section de passage pour le gaz entre une partie conductrice à l'électricité et une partie isolante à l'électricité. Cela permet notamment de limiter les turbulences du flux de gaz dans la conduite, et donc les risques de dépôt de résidu sur les parois.

Le dispositif 1 comprend un moyen pour appliquer localement au moins un potentiel électrique déterminé à la conduite entre sa première extrémité 3 haute et sa seconde extrémité 4 basse, au niveau de chaque partie électriquement conductrice. Le moyen d'application de potentiel permet d'appliquer plusieurs potentiels le long de la conduite, référencés $V_1$, $V_2$, $V_3$, $V_4$ sur la Figure 1.

La différence entre deux potentiels successifs $V_0$, $V_1$, $V_2$, $V_3$, $V_4$, et $V_5$ représente une fraction de la différence de potentiel $V_{RF}$ à laquelle est soumise la conduite 2. Ainsi, la somme desdites différences de potentiel est égale à la différence de potentiel $V_{RF}$ de la conduite 2 de gaz.

De préférence, la valeur d'un potentiel est supérieure ou égale à celle du potentiel qui le précède, et inférieure ou égale à celle du potentiel qui le suit, en considérant le sens de circulation du gaz dans la conduite, depuis sa première extrémité 3 vers sa seconde extrémité 4. Dans ce cas, l'inégalité suivante est vérifiée :

$$V_0 = 0 \leq V_1 \leq V_2 \leq V_3 \leq V_4 \leq V_5 = V_{RF}.$$

Dès lors, une première portion de conduite (de l'aval vers l'amont) est soumise à une différence de potentiel égale à $V_1$-$V_0$, et les portions de conduite adjacentes successives sont soumises respectivement à une différence de potentiel égale à $V_2$-$V_1$, $V_3$-$V_2$, $V_4$-$V_3$, et $V_5$-$V_4$.

Ainsi, en répartissant la différence de potentiel de la conduite 2 de gaz en au moins deux fractions, par application d'au moins un potentiel déterminé localisé au niveau du gaz circulant dans ladite conduite, on forme des « marches de potentiel ».

Selon un premier mode de réalisation de l'invention (non illustré), le moyen d'application d'un potentiel électrique comprend au moins une source de tension électrique permettant d'appliquer les valeurs de potentiel électrique le long de la conduite de gaz.

Selon un deuxième mode de réalisation de l'invention, le moyen d'application d'un potentiel électrique comprend une pluralité de modules d'impédance répartis le long de la conduite de gaz, entre deux parties électriquement conductrices successives, et reliés en série.

On désigne par « module d'impédance » tout composant électrique ou électronique possédant la propriété de s'opposer au passage d'un courant électrique.

Ainsi, selon le deuxième mode de réalisation de l'invention, un module d'impédance peut comprendre par exemple une résistance, une inductance, une bobine, ou encore un condensateur, ou une association de ces composants.

Dans le mode de réalisation illustré sur la Figure 1, la source de tension comprend cinq résistances, référencées 10a, 10b, 10c, 10d, et 10e, reliées en série entre la première extrémité 3 et la seconde extrémité 4 de la conduite 2 de gaz. Chaque jonction entre deux impédances successives est reliée électriquement à une partie électriquement conductrice 11 de la conduite en contact avec le gaz.

On notera que la représentation de la conduite 2 sous la forme d'un tube sur la figure 1 est purement schématique. Il va de soi que la géométrie intérieure et/ou extérieure de la conduite peut être adaptée pour permettre l'application du ou des potentiel(s) intermédiaire(s) susmentionnés et/ou pour connecter différentes parties de la conduite les unes avec les autres. L'homme du métier saura définir ces adaptations.

Par ailleurs, bien que la conduite 2 soit représentée rectiligne sur la figure 1, il va de soi que l'homme du métier pourra faire varier la géométrie de la conduite sans pour autant sortir du cadre de la présente invention.

L'invention peut notamment comprendre au moins une partie électriquement conductrice 11 avec une chambre traversante dite « non rectiligne » dans le sens où elle est agencée de sorte à définir un parcours du gaz non rectiligne.

Une telle chambre traversante non rectiligne permet d'une part d'augmenter la surface de gaz en contact avec le potentiel imposé, et d'autre part de créer une turbulence dans le flux de gaz pour augmenter la quantité de gaz en contact avec le potentiel imposé, sans affecter la longueur du dispositif.

Suivant des modes de réalisation, cette chambre traversante peut notamment comprendre :

-   une entrée et une sortie (au moins) de gaz décalées par rapport à la direction du flux de gaz, donc pas en vis-à-vis ;
-   une cavité de section cylindrique (ou de tout autre type de section) avec une entrée et une sortie (au moins) de gaz décalées par rapport à la direction du flux de gaz.

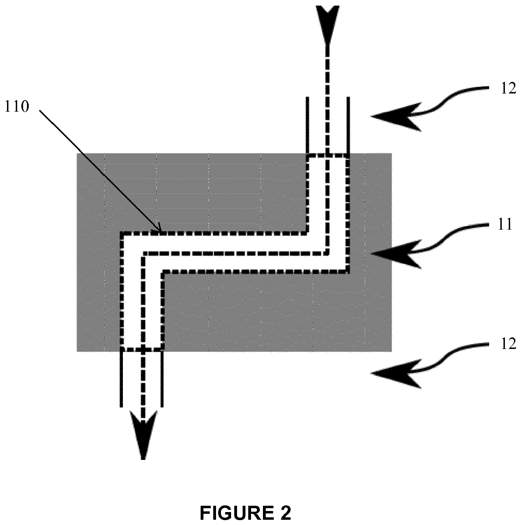

Selon un autre mode de réalisation illustré sur la figure 2, une partie électriquement conductrice 11 comprend une chambre traversante sous la forme d'un canal traversant 110 non rectiligne, comprenant par exemple un ou plusieurs coudes plus ou moins prononcés, et reliant une entrée et une sortie de gaz décalées par rapport à la direction du flux de gaz.

Naturellement, les géométries mentionnées et en particulier la géométrie présentée sur la figure 2 ne correspond qu'à une forme d'exécution particulière, l'homme du métier étant en mesure d'ajuster le parcours du gaz en fonction des conditions d'injection et des risques de génération de plasma.

Suivant d'autres modes de réalisation, l'invention peut comprendre au moins une partie électriquement conductrice 11 ajourée ou sous forme de treillis, ou encore comprenant une pluralité d'ouvertures permettant le passage du gaz au travers de ladite partie électriquement conductrice 11. Ces ouvertures peuvent être longitudinales dans le sens où elles sont orientées selon la direction du flux de gaz. Une telle disposition permet également d'augmenter la quantité de gaz en contact avec le potentiel imposé, sans affecter la longueur du dispositif.

Par ailleurs, les différentes parties électriquement conductrices 11 ne présentent pas nécessairement la même géométrie. De même, les différentes parties électriquement isolantes 12 ne présentent pas nécessairement la même géométrie ni la même longueur.

Un deuxième objet de l'invention concerne un réacteur 5 pour la mise en œuvre d'un procédé de dépôt chimique en phase gazeuse assisté par plasma (PECVD), comprenant un ou plusieurs dispositifs 1 précédemment décrits.

Le réacteur 5 est avantageusement muni d'une douche 6 (« showerhead » selon la terminologie anglo-saxonne) de distribution des gaz débouchant dans la chambre 13 du réacteur. Cette douche 6 comprend de préférence deux canaux d'injection de gaz. Elle reçoit les gaz en sortie d'une ou plusieurs conduites de gaz 2 et les injecte dans la chambre du réacteur. Ce faisant, les gaz distribués par la douche ont un potentiel égal à RF lors de leur entrée dans la chambre du réacteur. La douche de distribution est de préférence adaptée pour distribuer les gaz de manière homogène sur la surface d'un substrat 9 préalablement disposé sur un porte substrat 7 dans la chambre 13 de réaction, sur lequel un dépôt ultérieur doit être réalisé.

Une douche de distribution pouvant être utilisée dans la présente invention est décrite dans le document FR2930561.

De manière avantageuse, le réacteur comprend deux électrodes parallèles, dont une première électrode est reliée à une source radiofréquence, et une seconde électrode est reliée à la masse. La différence de potentiel entre la première et la seconde électrode permet de former un plasma du ou des gaz injecté(s) dans le réacteur 5 via une conduite d'injection de gaz.

De préférence, la première électrode comprend la douche de distribution des gaz 6 avec les canaux d'injection. La seconde électrode comprend le substrat 9 et le porte substrat 7.

Un avantage d'un réacteur comprenant un ou plusieurs dispositifs de circulation de gaz tels que décrits ci-dessus réside dans la possibilité de former un profil de champ électrique adapté aux paramètres du procédé de dépôt en phase gazeuse assisté par plasma (PECVD) mis en œuvre par ce réacteur.

Les paramètres du procédé PECVD comprennent par exemple : la nature du gaz précurseur et sa pression d'injection, la nature du gaz réactant et sa pression d'injection, la température de mise en œuvre du procédé, la taille du réacteur, l'intensité du champ électrique généré par les électrodes de la chambre du réacteur, ou encore le potentiel radiofréquence RF en sortie de conduite d'injection de gaz.

En outre l'invention permet de mettre en œuvre efficacement des procédé de dépôt en phase gazeuse assisté par plasma (PECVD) dans lesquels les gaz sont injectés dans la chambre du réacteur de manière impulsionnelle, ou sous forme d'impulsions, en phase ou déphasées dans le temps. En effet dans ce cas la densité de gaz dans les conduites est fortement variable au cours du temps, selon qu'une impulsion de gaz est en cours d'injection dans la chambre du réacteur ou non. Il s'ensuit que l'impédance électrique du milieu dans la conduite peut être également très variable spatialement et/ou temporellement et permettre localement l'apparition de champs électriques suffisamment intenses pour déclencher l'allumage d'un plasma. Dans ce cas, l'invention, en contrôlant localement les différences de potentiel présentes en tout point de la conduite permet d'éviter l'apparition de tels champs électriques excessifs.

## REFERENCES

- US 6,170,430; US2009/0324847
- FR 2930561; US 5,755,886

## Revendications

1. Dispositif (1) de circulation de gaz pour amener un gaz dans un réacteur de dépôt chimique en phase gazeuse, comprenant une conduite (2) avec une première extrémité (4) destinée à déboucher dans ledit réacteur en étant polarisée à un potentiel radiofréquence ($V_5$) et une seconde extrémité (3) électriquement polarisée à un potentiel de référence ($V_0$), le dispositif étant **caractérisé en ce que** la conduite comprend au moins une partie (11) conductrice à l'électricité agencée de sorte à être en contact avec le gaz circulant dans la conduite et environnée de parties (12) isolantes à l'électricité, et **en ce qu'**il comprend en outre un moyen (10a-10e) d'application de potentiel pour appliquer localement au moins un potentiel électrique déterminé à la conduite (2) entre la première et la seconde extrémité, de sorte à polariser localement le gaz dans ladite conduite à un potentiel électrique intermédiaire entre le potentiel radiofréquence et le potentiel de référence.

2. Dispositif selon la revendication 1, **caractérisé en ce que** le moyen d'application de potentiel comprend au moins une source de tension agencée de sorte à imposer un potentiel à une portion de la conduite.

3. Dispositif selon la revendication 1, **caractérisé en ce que** le moyen d'application de potentiel comprend un diviseur de tension électriquement relié selon deux bornes respectivement au potentiel de la première et la seconde extrémité de la conduite, ledit diviseur de tension comprenant une pluralité de modules d'impédance électrique reliés en série, au moins une jonction entre deux modules d'impédance électrique successifs étant reliée électriquement à la conduite.

4. Dispositif selon la revendication 3, **caractérisé en ce qu'**il comprend un module d'impédance électrique avec au moins l'un des composants suivants : une résistance, une inductance, une bobine, un condensateur.

5. Dispositif selon la revendication 5, **caractérisé en ce que** la conduite comprend une partie isolante à l'électricité de la forme d'une section de ladite conduite.

6. Dispositif selon l'une des revendications 5 ou 6, **caractérisé en ce que** la conduite comprend une partie conductrice à l'électricité de la forme d'une section de ladite conduite.

7. Dispositif selon l'une des revendications précédentes, **caractérisé en ce que** la conduite a une section intérieure sensiblement uniforme.

8. Dispositif selon l'une des revendication 5 à 8, **caractérisé en ce que** la conduite comprend une partie isolante à l'électricité de la forme d'une section de tube.

9. Dispositif selon la revendication 5, **caractérisé en ce que** la conduite comprend au moins une partie conductrice à l'électricité sous la forme d'une pièce en matériau conducteur à l'électricité avec au moins une chambre traversante (110) de circulation de gaz.

10. Dispositif selon la revendication 10, **caractérisé en ce que** ladite chambre traversante définit un parcours non rectiligne du gaz dans ladite partie conductrice à l'électricité.

11. Dispositif selon la revendication 5, **caractérisé en ce que** la conduite comprend au moins une partie conductrice à l'électricité sous la forme d'une pièce en matériau conducteur à l'électricité avec une pluralité d'ouvertures permettant la circulation du gaz.

12. Réacteur pour la mise en oeuvre d'un procédé de dépôt chimique en phase gazeuse, **caractérisé en ce qu'**il comprend une chambre de réaction et au moins un dispositif de circulation de gaz selon l'une des revendications 1 à 12.

13. Réacteur selon la revendication 13, **caractérisé en ce qu'**il comprend deux électrodes, dont une première électrode est reliée à une source radiofréquence, et une seconde électrode est reliée à la masse, de sorte que la différence de potentiel entre la première et la seconde électrode permet de former un plasma du ou des gaz injecté(s) dans le réacteur.

14. Procédé pour éviter la formation de plasma dans un dispositif de circulation de gaz pour amener un gaz dans un réacteur de dépôt chimique en phase gazeuse, comprenant une conduite avec une première extrémité débouchant dans ledit réacteur en étant polarisée à un potentiel radiofréquence ($V_5$) et une seconde extrémité électriquement polarisée à un potentiel de référence ($V_0$), la conduite comprenant au moins une partie (11) conductrice à l'électricité agencée de sorte à être en contact avec le gaz circulant dans la conduite et environnée de parties (12) isolantes à l'électricité, ledit procédé étant **caractérisé en ce qu'**il comprend une application localement d'au moins un potentiel électrique déterminé à la conduite entre la première et la seconde extrémité, de sorte à polariser localement le gaz dans ladite conduite à un potentiel électrique intermédiaire entre le potentiel radiofréquence et le potentiel de référence.

15. Procédé de dépôt chimique en phase gazeuse, **caractérisé en ce qu'**il est mis en oeuvre dans un réacteur selon l'une des revendications 13 ou 14, le procédé comprenant une étape d'injection, via un dispositif de circulation de gaz selon l'une des revendications 1 à 12, d'un gaz destiné à réagir à la surface d'un substrat préalablement positionné dans la chambre de réaction du réacteur.

**Patentansprüche**

1. Gasströmungsvorrichtung (1) zur Zuführung eines Gases in einen Reaktor zur chemischen Gasphasenabscheidung, die eine Leitung (2) mit einem ersten Ende (4) umfasst, das dazu bestimmt ist, in den Reaktor zu münden, wobei es auf ein Radiofrequenzpotential (V5) polarisiert ist, und einem zweiten Ende (3), das elektrisch auf ein Referenzpotential (Vo) polarisiert ist, **dadurch gekennzeichnet, dass** die Leitung mindestens einen elektrisch leitenden Teil (11) umfasst, der so angeordnet ist, dass er mit dem in der Leitung strömenden Gas in Kontakt steht und von elektrisch isolierenden Teilen (12) umgeben ist, und dadurch, dass sie außerdem ein Mittel zum Anlegen von Potentialen (10a-10e) umfasst, um lokal mindestens ein bestimmtes elektrisches Potential an die Leitung (2) zwischen dem ersten und dem zweiten Ende anzulegen, so dass das Gas in der Leitung lokal auf ein elektrisches Potential polarisiert werden kann, das zwischen dem Radiofrequenzpotential und dem Referenzpotential liegt.

2. Vorrichtung nach Anspruch 1, **dadurch gekennzeichnet, dass** das Mittel zum Anlegen eines Potentials mindestens eine Spannungsquelle umfasst, die so angeordnet ist, dass sie in einem Abschnitt der Leitung ein Potential vorgibt.

3. Vorrichtung nach Anspruch 1, **dadurch gekennzeichnet, dass** das Mittel zum Anlegen eines Potentials einen Spannungsteiler umfasst, der entlang zweier Klemmen jeweils mit dem Potential des ersten und des zweiten Endes der Leitung elektrisch verbunden ist, wobei der Spannungsteiler eine Vielzahl von in Reihe geschalteten elektrischen Impedanzmodulen umfasst, wobei mindestens eine Verbindung zwischen zwei aufeinander folgenden elektrischen Impedanzmodulen elektrisch mit der Leitung verbunden ist.

4. Vorrichtung nach Anspruch 3, **dadurch gekennzeichnet, dass** sie ein elektrisches Impedanzmodul mit mindestens einem der folgenden Komponenten umfasst: einem Widerstand, einer Drossel, einer Spule und einem Kondensator.

5. Vorrichtung nach Anspruch 5, **dadurch gekennzeichnet, dass** die Leitung einen elektrisch isolierenden Teil in Form eines Abschnitts der Leitung umfasst.

6. Vorrichtung nach einem der Ansprüche 5 oder 6, **dadurch gekennzeichnet, dass** die Leitung einen elektrisch leitenden Teil in Form eines Abschnitts der Leitung umfasst.

7. Vorrichtung nach einem der vorhergehenden Ansprüche, **dadurch gekennzeichnet, dass** die Leitung einen im wesentlichen gleichmäßigen Innenquerschnitt hat.

8. Vorrichtung nach einem der Ansprüche 5 bis 8, **dadurch gekennzeichnet, dass** die Leitung einen elektrisch isolierenden Teil in Form eines Rohrabschnitts aufweist.

9. Vorrichtung nach Anspruch 5, **dadurch gekennzeichnet, dass** die Leitung mindestens einen elektrisch leitenden Teil in Form eines Stückes aus elektrisch leitendem Material mit mindestens einer Durchgangskammer (110) für die Gasströmung umfasst.

10. Vorrichtung nach Anspruch 10, **dadurch gekennzeichnet, dass** die Durchgangskammer im elektrisch leitenden Teil für das Gas einen nicht geradlinigen Weg abgrenzt.

11. Vorrichtung nach Anspruch 5, **dadurch gekennzeichnet, dass** die Leitung mindestens einen elektrisch leitfähigen Teil in Form eines Stücks aus elektrisch leitfähigem Material mit einer Vielzahl von Öffnungen umfasst, die das Strömen des Gases ermöglichen.

12. Reaktor zur Durchführung eines Verfahrens zur chemischen Gasphasenabscheidung, **dadurch gekennzeichnet, dass** er eine Reaktionskammer und mindestens eine Gasströmungsvorrichtung nach einem der Ansprüche 1 bis 12 umfasst.

13. Reaktor nach Anspruch 13, **dadurch gekennzeichnet, dass** er zwei Elektroden umfasst, von denen eine erste Elektrode mit einer Radiofrequenzquelle verbunden und die zweite Elektrode geerdet ist, so dass die Potentialdifferenz zwischen der ersten und der zweiten Elektrode die Bildung eines Plasmas des oder der in den Reaktor eingeleiteten Gase ermöglicht.

14. Verfahren zur Vermeidung der Bildung von Plasma in einer Gasströmungsvorrichtung zur Zuführung eines Gases in einen Reaktor zur chemischen Gasphasenabscheidung, die eine Leitung mit einem ersten Ende umfasst, das in den Reaktor mündet und auf ein Radiofrequenzpotential (V5) polarisiert ist, und einem zweiten Ende, das elektrisch auf ein Referenzpotential (Vo) polarisiert ist, wobei die Leitung mindestens einen elektrisch leitenden Teil (11) umfasst, der so angeordnet ist, dass er mit dem in der Leitung strömenden Gas in Kontakt steht und von elektrisch isolierenden Teilen (12) umgeben ist, wobei das Verfahren **dadurch gekennzeichnet ist, dass** es das lokale Anlegen mindestens eines bestimmten elektrischen Potentials an die Leitung zwischen dem ersten und dem zweiten Ende umfasst, so dass das Gas in der Leitung lokal auf ein elektrisches Potential polarisiert werden kann, das zwischen dem Radiofrequenzpotential und dem Referenzpotential liegt.

15. Verfahren der chemischen Gasphasenabscheidung, **dadurch gekennzeichnet, dass** es in einem Reaktor nach einem der Ansprüche 13 oder 14 durchgeführt wird, wobei das Verfahren einen Schritt der Einleitung eines Gases über eine Gasströmungsvorrichtung nach einem der Ansprüche 13 oder 14 in den Reaktor umfasst, wobei das Gas dazu bestimmt ist, an der Oberfläche eines vorab in die Reaktionskammer des Reaktors platzierten Substrats zu reagieren.

**Claims**

1. A gas circulation device (1) for conveying a gas into a chemical vapour deposition reactor, comprising a conduit (2) with a first end (4) intended to open into said reactor being polarised at a radiofrequency potential (V5) and a second end (3) electrically polarised at a reference potential (Vo), the device being **characterised in that** the conduit comprises at least one electrically conductive portion (11) so arranged as to be in contact with the gas flowing in the conduit and surrounded by electrically insulating portions (12), and **in that** it further comprises potential application means (10a-10e) for locally applying at least one determined electrical potential to the conduit (2) between the first and the second ends, so as to locally polarise the gas in said conduit at an electrical potential intermediate between the radio frequency potential and the reference potential.

2. The device according to claim 1, **characterised in that** the potential application means comprises at least one voltage source so arranged as to impose a potential on a portion of the conduit.

3. A device according to claim 1, **characterised in that** the potential application means comprises a voltage divider electrically connected according to two terminals respectively to the potential of the first and the second end of the conduit, said voltage divider comprising a plurality of electrical impedance modules connected in series, at least one junction between two successive electrical impedance modules being electrically connected to the conduit.

4. A device according to claim 3, **characterised in that** it comprises an electrical impedance module with at least one of the following components: a resistor, an inductance, a coil, a capacitor.

5. A device according to claim 5, **characterised in that** the conduit comprises an electrically insulating portion in the form of a section of said conduit.

6. A device according to one of claims 5 or 6, **characterised in that** the conduit comprises an electrically conductive portion having the shape of a section of said conduit.

7. A device according to one of the preceding claims, **characterised in that** the conduit has a substantially uniform internal section.

8. A device according to one of claims 5 to 8, **charac-**

**terised in that** the conduit comprises an electrically insulating portion having the shape of a tube section.

9. A device according to claim 5, **characterised in that** the conduit comprises at least one electrically conductive portion in the form of a portion made of electrically conductive material with at least one gas circulation through-chamber (110).

10. A device according to claim 10, **characterised in that** said through-chamber defines a non-rectilinear gas path in said electrically conductive portion.

11. A device according to claim 5, **characterised in that** the conduit comprises at least one electrically conductive portion in the form of a portion made of electrically conductive material with a plurality of openings for gas circulation.

12. A reactor for implementing a chemical vapour deposition method, **characterised in that** it comprises a reaction chamber and at least one gas circulation device according to one of claims 1 to 12.

13. A reactor according to claim 13, **characterised in that** it comprises two electrodes, a first electrode of which is connected to a radiofrequency source, and a second electrode is connected to the ground, so that the potential difference between the first and the second electrodes allows to form a plasma of the gas(es) injected into the reactor.

14. A method for preventing plasma formation in a gas circulation device for conveying a gas into a chemical vapour deposition reactor, comprising a conduit with a first end opening into said reactor being polarised at a radiofrequency potential (V5) and a second end electrically polarised at a reference potential (Vo), the conduit comprising at least one electrically conductive portion (11) so arranged as to be in contact with the gas flowing in the conduit and surrounded by electrically insulating portions (12), said method being **characterised in that** it comprises a local application of at least one determined electrical potential to the conduit between the first and the second ends, so as to locally polarise the gas in said conduit at an electrical potential intermediate between the radio frequency potential and the reference potential.

15. A method for chemical vapour deposition, **characterised in that** it is implemented in a reactor according to one of claims 13 or 14, the method comprising a step of injecting, via a gas circulation device according to one of claims 1 to 12, a gas intended for reacting on the surface of a substrate previously positioned in the reaction chamber of the reactor.

**FIGURE 1**

**FIGURE 2**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6170430 B
- US 20090324847 A
- US 5755886 A
- FR 2930561